Europäisches Patentamt

European Patent Office

Office européen des brevets

(19)

(11) Veröffentlichungsnummer : **0 092 049**
**B1**

(12)             EUROPÄISCHE PATENTSCHRIFT

(45) Veröffentlichungstag der Patentschrift :
30.12.86

(21) Anmeldenummer : 83102436.9

(22) Anmeldetag : 11.03.83

(51) Int. Cl.⁴ : **H 05 K   7/20**, F 24 F 13/08

(54) Lüftungsgitter für Gerätegehäuse.

(30) Priorität : 21.04.82 DE 3214823

(43) Veröffentlichungstag der Anmeldung :
26.10.83 Patentblatt 83/43

(45) Bekanntmachung des Hinweises auf die Patenterteilung : 30.12.86 Patentblatt 86/52

(84) Benannte Vertragsstaaten :
DE FR GB IT

(56) Entgegenhaltungen :
FR-A-   743 204
FR-A- 2 045 280
FR-A- 2 071 099
US-A- 3 452 666

(73) Patentinhaber : Nixdorf Computer Aktiengesellschaft
Fürstenallee 7
D-4790 Paderborn (DE)

(72) Erfinder : Knoop, Franz J.
Sonnenhang 7
D-4793 Büren-Steinhausen (DE)

(74) Vertreter : Patentanwälte Schaumburg & Thoenes
Mauerkircherstrasse 31 Postfach 86 07 48
D-8000 München 80 (DE)

## Beschreibung

Die Erfindung betrifft ein Lüftungsgitter für Gerätegehäuse mit einer Vielzahl von parallel gerichteten, miteinander verbundenen Rippen, zwischen denen Lüftungsschlitze ausgebildet sind, wobei die Rippen von einer Seite einer einstückig mit ihnen ausgeformten Platte abstehen.

Derartige Lüftungsgitter sollen einerseits einen ausreichenden Luftaustausch zwischen dem Gehäuseinnenraum und dem Gehäuseaußenraum zulassen, andererseits jedoch den Einblick in das Gerätegehäuse verwehren und den Gehäuseinnenraum gegen Störstrahlung abschirmen, wenn in dem Gehäuse elektronische Baugruppen untergebracht sind. Zu diesem Zweck sind bereits Lüftungsgitter der eingangs genannten Art bekannt, bei denen die Lüftungsschlitze labyrinthartig ausgebildet sind. Dabei werden die Rippen oder Lamellen des Lüftungsgitters einzeln gefertigt, über Querstreben miteinander verbunden, beispielsweise verschweißt und schließlich mit einem Rahmen verbunden, der dem Lüftungsgitter die erforderliche Stabilität verleiht und zur Befestigung des Lüftungsgitters an dem Gerätegehäuse dient. Diese Bauweise des Lüftungsgitters erfordert einen hohen Fertigungsaufwand und damit auch hohe Herstellungskosten.

Aus der FR-A-2045280 ist ferner ein Lüftungsgitter der eingangs genannten Art bekannt, bei dem die Lüftungsschlitze in den zwischen den Rippen verlaufenden Stegen ausgebildet sind. Dieses Lüftungsgitter verhindert weder den Einblick in das Gerätegehäuse noch gewährleistet es eine zuverlässige Abschirmung gegenüber Störstrahlung.

Der Erfindung liegt die Aufgabe zugrunde, ein Lüftungsgitter der eingangs genannten Art anzugeben, das mit geringem Fertigungsaufwand herstellbar ist und dennoch eine ausreichende Lüftung und Abschirmung gewährleistet sowie den Einblick in das Gerätegehäuse verhindert.

Diese Aufgabe wird erfindungsgemäß dadurch gelöst, daß zwischen den Rippen Streifen der Platte unter Bildung der Lüftungsschlitze nach der den Rippen abgewandten Plattenseite herausgehoben sind und daß das Lüftungsgitter auf mindestens einer Seite eine metallische Oberfläche aufweist.

Bei einem Blick senkrecht auf die Platte werden die Lüftungsschlitze durch die Streifen verdeckt, so daß die Streifen in Verbindung mit den Rippen labyrinthartige Durchtrittsöffnungen bilden, die einen Einblick sowie den direkten Eintritt von Störstrahlung in das Gerätegehäuse verhindern.

Bei einer besonders preisgünstigen Ausführungsform besteht das Lüftungsgitter aus Kunststoff. In diesem Falle kann das Lüftungsgitter in einem einzigen Arbeitsgang mit der gewünschten Oberflächengestaltung und Farbe als Spritzgußteil hergestellt werden. Zur Abschirmung gegen Störstrahlung ist das Lüftungsgitter auf mindestens einer Seite mit einer Metallschicht versehen werden, die beispielsweise aufgedampft wird.

Eine verbesserte Abschirmwirkung ergibt sich, wenn das Lüftungsgitter aus Metall, insbesondere Aluminium besteht. In diesem Fall kann das Lüftungsgitter in kostengünstiger Weise so hergestellt werden, daß zunächst ein Strangprofil mit einer durchgehenden Platte gebildet wird, von deren einer Seite die Rippen abstehen, und daß anschließend zwischen je zwei Rippen zwei parallel zu diesen verlaufende Schlitze erzeugt und der zwischen den Schlitzen befindliche Streifen nach der den Rippen abgewandten Seite der Platte durchgedrückt wird. Dabei können in einem einzigen Stanzvorgang eine beliebige Anzahl von nebeneinander liegenden Lüftungsschlitzen erzeugt werden. Dieses Herstellungsverfahren hat auch den Vorteil, daß wegen der beliebigen Länge des Stranprofiles mit denselben Werkzeugen Lüftungsgitter unterschiedlicher Länge hergestellt werden können. Zu diesem Zwecke ist es auch zweckmäßig, wenn die Lüftungsschlitze sich jeweils nur über eine relativ kurze Länge erstrecken, so daß die zu ihrer Herstellung erforderlichen Stanzwerkzeuge je nach Länge des Lüftungsgitters — in Längsrichtung des Lüftungsgitters betrachtet — mehrfach zur Anwendung kommen und mehrere Blöcke von Lüftungsschlitzen erzeugen, die jeweils durch nicht verformte Bereiche der Platte voneinander getrennt sind. Diese Unterteilung der Lüftungsschlitze in einzelne Abschnitte ist auch bei der oben beschriebenen Ausführungsform des Lüftungsgitters als Spritzgußteil vorzuziehen, da dadurch die Stabilität des Lüftungsgitters erhöht wird.

Weitere Merkmale und Vorteile der Erfindung ergeben sich aus der folgenden Beschreibung, welche in Verbindung mit den beifügten Zeichnungen die Erfindung anhand eines Ausführungsbeispieles erläutert. Es zeigen :

Figur 1 eine Draufsicht auf die die Rippen tragende Seite eines teilweise fertiggestellten Lüftungsgitters,

Figur 2 einen Schnitt längs Linie II-II in Fig. 1, und

Figur 3 eine Endansicht des in der Fig. 1 dargestellten Lüftungsgitters in Richtung des Pfeiles A.

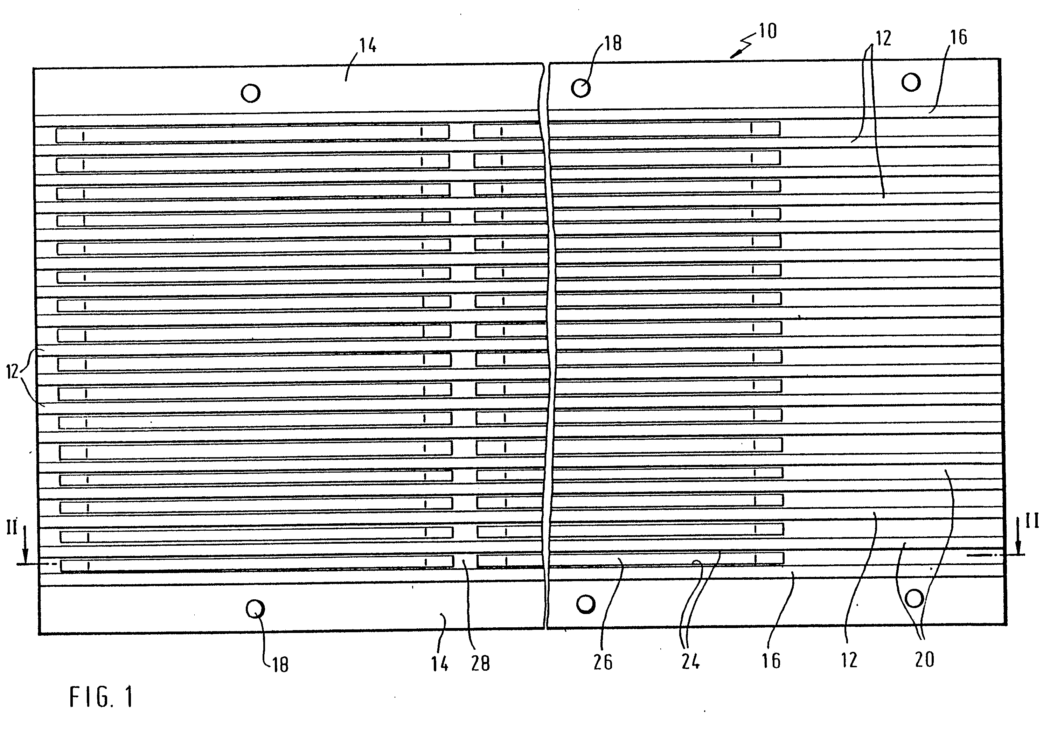

In den Fig. 1 bis 3 erkennt man eine als Strangprofil hergestellte rechteckige Platte 10 von deren einer Seite einstückig mit ihr ausgebildete Rippen 12 senkrecht abstehen. Die Rippen 12 verlaufen mit gleichmäßigen Zwischenräumen parallel zu den Längsrändern der Platte 10. Entlang der Längsränder der Platte 10 erstreckt sich jeweils ein von Rippen freier Randstreifen 14, der gegenüber den Rippen durch einen Randsteg 16 abgegrenzt ist. In dem Randstreifen 14 sind Löcher 18 ausgebildet, die zur Befestigung des Lüftungsgitters an der Wand eines Gerätegehäuses dienen, wobei die Randstege 16 und die Rippen 12 in eine Öffnung der Gehäusewand eingreifen, deren Breite im wesentlichen gleich dem Abstand der Außenseiten der Randstege 16 voneinander ist.

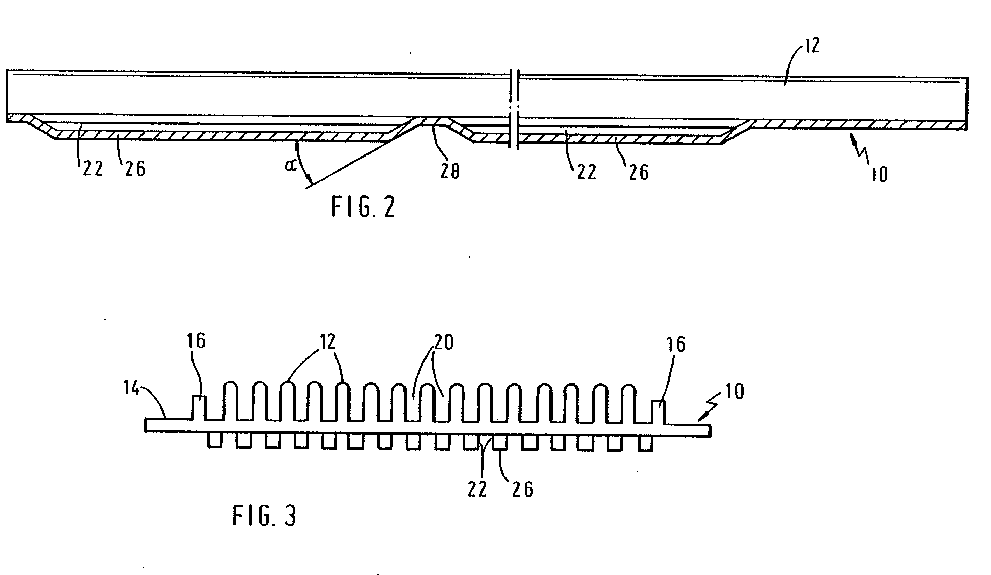

In den Zwischenräumen 20 zwischen je zwei Rippen 12 sind Lüftungsschlitze 22 (Fig. 2) ausgebildet. Zu ihrer Herstellung werden zunächst zwischen je zwei Rippen 12 zwei sich über eine gewisse Länge erstreckende Schlitze 24 beispielsweise durch Stanzen erzeugt. Anschließend wird der zwischen den Schlitzen 24 verbleibende Materialstreifen 26 nach der den Rippen 12 abgewandten Seite der Platte 10 hin durchgedrückt, wie man dies insbesondere in der Fig. 2 erkennt. Die Streifen 26 verlaufen dabei über den größten Teil ihrer Länge parallel zu der Platte 10 und bilden lediglich in den Endbereichen, in denen sie mit der Platte 10 zusammenhängen, mit dieser einen Winkel α von ca. 30°.

Wie man in den Fig. 1 und 2 erkennt, erstrecken sich die Lüftungsschlitze 22 nicht über die gesamte Länge der Platte 10, sondern sind in einzelne gleichlange Abschnitte unterteilt. Dabei bilden die in einem Längenbereich der Platte 10 nebeneinander ausgebildeten Lüftungsschlitze 22 einen Block, der beispielsweise mit einem Stanzwerkzeug in einem Arbeitsgang hergestellt werden kann. Je nach Länge der Platte 10 können mehrere solcher Blöcke von Lüftungsschlitzen 22 nebeneinander angeordnet werden, wie dies in den Fig. 1 und 2 angedeutet ist, in denen man zwei derartige Blöcke erkennt, die durch einen Stegbereich 28 voneinander getrennt sind, in dem das Strangprofil der Platte 10 nicht verformt ist.

In der rechten Hälfte der Fig. 1 und 2 ist ein unverformter Teil des Strangprofils dargestellt, der entweder abgeschnitten werden kann oder in dem weitere Blöcke von Lüftungsschlitzen erzeugt werden können, wenn eine größere Länge des Lüftungsgitters erwünscht ist.

Es ist auch möglich, das Stanzwerkzeug so auszubilden, daß nur eine kleinere Anzahl von nebeneinander liegenden Lüftungsschlitzen in einem Arbeitsschritt erzeugt wird und daß der gesamte Block von Lüftungsschlitzen durch mehrere aufeinander folgende Stanzvorgänge hergestellt wird, wobei das Stanzwerkzeug nach jedem Stanzvorgang quer zur Längsrichtung des Strangprofiles versetzt wird. Dies erlaubt auf einfache Weise auch die Herstellung unterschiedlich breiter Lüftungsgitter, wobei natürlich auch unterschiedlich breite Strangprofile erzeugt werden müssen.

Das vorstehend beschriebene Herstellungsverfahren eignet sich insbesondere zur Herstellung von Lüftungsgittern aus Aluminium. Die Herstellung von Lüftungsgittern aus Kunststoff kann auch in einfacher Weise dadurch erfolgen, daß das Lüftungsgitter in einem einzigen Arbeitsschritt bereits mit ausgeformten Lüftungsschlitzen als Spritzgußteil hergestellt wird.

Die Abschirmwirkung gegenüber Hochfrequenzstrahlung hängt von dem zur Herstellung des Lüftungsgitters verwendeten Material, der Stärke der Platte 10 und den Abmessungen der Rippen 12 und der Streifen 26 sowie der Luftschlitze 22 ab. Ferner spielt es beispielsweise eine Rolle, ob ein aus Kunststoff hergestelltes Lüftungsgitter mit einer Metallschicht versehen ist. Bei einer bevorzugten Ausführungsform wurden folgende Abmessungen gewählt:

Die Stärke der Platte 10 beträgt etwa 2 mm. Die Stärke der Rippen und ihre Höhe betragen 3 bzw. 10 mm. Der gegenseitige Abstand der Rippen beträgt ca. 4 mm. Die etwa 3,5 mm breiten Streifen 26 sind um ca. 4 mm aus der Ebene der Platte 10 herausgedrückt und besitzen eine Länge von ca. 95 mm. Bei Vergleichsmessungen an einem aus Kunststoff hergestellten Lüftungsgitter und einem aus Aluminium hergestellten Lüftungsgitter im Bereich von 30 MHz bis 1 GHz hat sich herausgestellt, daß die Abschirmwirkung des aus Aluminium bestehenden Lüftungsgitters gegenüber Störstrahlung um ca. 17 bis 25 dβ höherliegt als bei einem aus Kunststoff bestehenden Lüftungsgitter.

## Patentansprüche

1. Lüftungsgitter für Gerätegehäuse mit einer Vielzahl von parallel gerichteten, miteinander verbundenen Rippen (12), zwischen denen Lüftungsschlitze (22) ausgebildet sind, wobei die Rippen (12) von einer Seite einer einstückig mit ihnen ausgeformten Platte (10) abstehen, dadurch gekennzeichnet, daß zwischen den Rippen (12) Streifen (26) der Platte (10) unter Bildung der Lüftungsschlitze (22) nach der den Rippen (12) abgewandten Plattenseite herausgehoben sind und daß das Lüftungsgitter auf mindestens einer Seite eine metallische Oberfläche aufweist.

2. Lüftungsgitter nach Anspruch 1, dadurch gekennzeichnet, daß die Lüftungsschlitze (22) sich jeweils nur über einen Teil der Länge des Lüftungsgitters erstrecken, wobei mehrere Lüftungsschlitze (22) durch Stege (28) getrennt in Längsrichtung hintereinander angeordnet sind.

3. Lüftungsgitter nach Anspruch 1 oder 2, dadurch gekennzeichnet, daß es aus Kunststoff hergestellt und auf mindestens einer Seite mit einer Metallschicht versehen ist.

4. Lüftungsgitter nach Anspruch 1 oder 2, dadurch gekennzeichnet, daß es aus Metall, insbesondere Aluminium besteht.

5. Verfahren zur Herstellung eines Lüftungsgitters für Gerätegehäuse mit einer Vielzahl von parallel gerichteten, miteinander verbundenen Rippen (12) und zwischen diesen ausgebildeten Lüftungsschlitzen (22), dadurch gekennzeichnet, daß zunächst ein metallisches Strangprofil mit einer durchgehenden Platte (10) gebildet wird, von dessen einer Seite die Rippen (12) abstehen, und daß anschließend zwischen je zwei Rippen (12) jeweils zwei parallel zu diesen verlaufende Schlitze (24) erzeugt und der zwischen den Schlitzen (24) befindliche Streifen (26) nach der den Rippen (12) abgewandten Plattenseite durchgedrückt wird.

0 092 049

## Claims

1. A ventilation grille for apparatus housings, comprising a plurality of parallel ribs (12) connected to each other, vent slots (22) being formed between the ribs, wherein said ribs (12) project from one side of a plate (10) which is integral with said ribs, characterized in that strips (26) of said plate (10) project from between the ribs (12) away from the side of the plate opposite to said ribs (12), thus forming said vent slots (22), and that said ventilation grille has a metallic surface on at least one side.

2. Ventilation grille as claimed in Claim 1, characterized in that said vent slots (22) respectively extend only along a part of the length of said ventilation grille, wherein several vent slots (22) are arranged one after another in longitudinal direction and separated by bars (28).

3. Ventilation grille as claimed in Claim 1 or 2, characterized in that it consists of plastic and is provided with a metal layer on at least one side.

4. Ventilation grille as claimed in Claim 1 or 2, characterized in that it consists of metal, in particular aluminium.

5. Process for the production of a ventilation grille for apparatus housings, comprising a plurality of parallel ribs (12) connected to each other, and vent slots (22) formed therebetween, characterized in that, firstly, a continuous metallic plate (10) is extruded, the ribs (12) projecting from one side thereof, and that, secondly, two slots (22) are respectively formed between two ribs (12), said slots extending parallel to said ribs, and that the strip (26), located between said slots (24), is forced through to the side of the plate opposite to said ribs (12).

## Revendications

1. Grille d'aération pour boitier d'appareil comportant une multiplicité de nervures parallèles (12) reliées ensemble, entre lesquelles sont formées des fentes d'aération (22), les nervures (12) partant d'un côté d'une plaque (10) formée d'une seule pièce avec elles, caractérisée en ce qu'entre les nervures (12) des bandes (26) de la plaque (10) sont repoussées vers le côté de la plaque opposé aux nervures (12) en formant les fentes d'aération (22), et la grille d'aération comporte une surface métallique sur au moins un côté.

2. Grille d'aération selon la revendication 1, caractérisée en ce que les fentes d'aération (22) ne s'étendent respectivement que sur une partie de la longueur de la grille d'aération, plusieurs fentes d'aération séparées par des bandes (28) étant disposées l'une derrière l'autre dans le sens de la longueur.

3. Grille d'aération selon la revendication 1 ou 2, caractérisée en ce qu'elle est fabriquée en matière plastique et est munie d'une couche métallique au moins sur un côté.

4. Grille d'aération selon la revendication 1 ou 2, caractérisée en ce qu'elle est en métal, notamment en aluminium.

5. Procédé pour fabriquer une grille d'aération pour boitier d'appareil, comportant une multiplicité de nervures (12) parallèles reliées ensemble, et des fentes d'aération (22) formées entre celles-ci, caractérisé en ce qu'on forme d'abord un profilé métallique extrudé avec une plaque continue (10) d'un côté de laquelle partent des nervures (12), et ensuite on produit respectivement entre deux nervures (12) des fentes (24) s'étendant parallèlement à celles-ci, et la bande (26) se trouvant entre les fentes (24) est enfoncée vers le côté de la plaque opposé aux nervures (12).

4

FIG. 1

0 092 049

FIG. 2

FIG. 3